(19) Europäisches Patentamt / European Patent Office / Office européen des brevets

(11) **EP 2 904 410 B1**

(12) **FASCICULE DE BREVET EUROPEEN**

(45) Date de publication et mention
de la délivrance du brevet:
**22.05.2019 Bulletin 2019/21**

(21) Numéro de dépôt: **13762156.1**

(22) Date de dépôt: **16.09.2013**

(51) Int Cl.:
*G01R 22/06* (2006.01)          *G01R 22/10* (2006.01)
*H02H 11/00* (2006.01)          *G01R 27/16* (2006.01)

(86) Numéro de dépôt international:
**PCT/EP2013/069175**

(87) Numéro de publication internationale:
**WO 2014/053302 (10.04.2014 Gazette 2014/15)**

(54) **COMPTEUR D'ENERGIE ELECTRIQUE**

STROMMESSER

ELECTRIC POWER METER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.10.2012 FR 1259296**

(43) Date de publication de la demande:
**12.08.2015 Bulletin 2015/33**

(73) Titulaire: **Sagemcom Energy & Telecom SAS
92500 Rueil-Malmaison (FR)**

(72) Inventeurs:
• **JEANROT, Marc
  F-92500 Rueil Malmaison (FR)**
• **GINESTET, Patrick
  F-92500 Rueil Malmaison (FR)**

(74) Mandataire: **Lavialle, Bruno François Stéphane et
al
Cabinet Boettcher
16, rue Médéric
75017 Paris (FR)**

(56) Documents cités:
**FR-A1- 2 947 055          GB-A- 2 281 401
GB-A- 2 313 201          KR-B1- 100 868 892
US-A- 5 940 009          US-A1- 2008 258 709
US-A1- 2009 261 805**

## Description

L'invention concerne un compteur d'énergie électrique.

### ARRIERE PLAN DE L'INVENTION

La plupart des compteurs d'énergie électriques modernes comportent un organe de coupure qu'un distributeur d'énergie peut commander à distance. Cet organe de coupure permet notamment au distributeur de couper ou de rétablir une alimentation en énergie électrique provenant d'une ligne électrique d'un réseau de distribution à laquelle un compteur raccorde une installation électrique d'un utilisateur (en cas de résiliation d'un abonnement ou en cas d'emménagement de l'utilisateur dans un nouveau logement par exemple), sans qu'il soit nécessaire d'envoyer du personnel sur place.

Dans certains cas, les distributeurs souhaitent en outre que l'organe de coupure du compteur puisse être réarmé suite à une manipulation volontaire par l'utilisateur d'un disjoncteur de l'installation, en général une ouverture suivie d'une fermeture du disjoncteur.

Ainsi, avant de commander le réarmement de l'organe de coupure, le compteur électrique doit pouvoir détecter la manipulation du disjoncteur. Cette détection peut être réalisée par une détection de variation d'une impédance aux bornes de l'installation, laquelle impédance est relativement faible lorsque le disjoncteur est fermé, et relativement forte lorsqu'il est ouvert.

Or, la plupart des dispositifs existants permettant de détecter une variation d'impédance d'une installation fonctionnent uniquement sur des compteurs référencés à la phase (c'est-à-dire qu'une masse électrique du compteur est reliée à une phase de la ligne), ce qui est le cas de la plupart des compteurs monophasés, mais ne fonctionnent pas sur des compteurs référencés au neutre, ce qui est le cas de la plupart des compteurs triphasés.

De plus, le document FR-2 947 055 A1 décrit un compteur électrique équipé d'un dispositif de surveillance des différences de potentiel entre un premier potentiel donné par un conducteur de phase et un second potentiel du compteur.

### OBJET DE L'INVENTION

L'invention a pour objet de permettre à un compteur d'énergie électrique référencé au neutre de détecter une manipulation d'un disjoncteur d'une installation électrique de manière à pouvoir commander un réarmement d'un organe de coupure du compteur.

### RESUME DE L'INVENTION

En vue de la réalisation de ce but, on propose un compteur d'énergie électrique comportant des moyens de son raccordement à un réseau de distribution et à des bornes d'une installation électrique, des moyens de mesure amont d'une tension de phase du réseau, des moyens de mesure d'un courant de phase circulant sous la tension de phase, un organe de coupure pour sélectivement connecter et déconnecter le réseau et les bornes, des moyens de mesure aval d'une tension aval aux bornes de l'installation, et des moyens de traitement pour piloter l'organe de coupure entre un état ouvert et un état fermé et acquérir des mesures réalisées par les moyens de mesure. Selon l'invention, le compteur comporte des moyens d'amenée d'une tension de mesure aux bornes de l'installation lorsque l'organe de coupure est ouvert, des moyens de mesure d'impédance connectés aux moyens d'amenée pour mesurer une impédance de l'installation, et au moins un interrupteur de mesure connecté à une première résistance de mesure des moyens de mesure aval et commandé par les moyens de traitement pour sélectivement connecter et déconnecter la première résistance de mesure et les moyens d'amenée selon qu'une mesure de tension aval ou qu'une mesure d'impédance est commandée.

Le compteur peut donc détecter l'état (ouvert ou fermé) de l'organe de coupure grâce aux moyens de mesure aval de la tension aval, puis, dans le cas où l'organe de coupure est ouvert, mesurer l'impédance de l'installation grâce aux moyens d'amenée et aux moyens de mesure d'impédance. On peut ainsi détecter une manipulation d'un disjoncteur de l'installation, et donc commander le réarmement de l'organe de coupure. Une précision suffisante de la mesure de tension aval et de la mesure d'impédance est assurée grâce à l'interrupteur qui est adapté à connecter et déconnecter la première résistance de mesure. Aucun des moyens précédemment cités du compteur de l'invention ne nécessite de connexion d'une masse électrique du compteur à un conducteur de neutre d'une ligne du réseau de distribution.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :

- la figure 1 représente un schéma électrique d'un compteur de l'invention selon un premier mode de mise en oeuvre ;
- la figure 2 représente un compteur électrique de l'invention selon une variante du premier mode de mise en oeuvre.

### DESCRIPTION DETAILLEE DE L'INVENTION

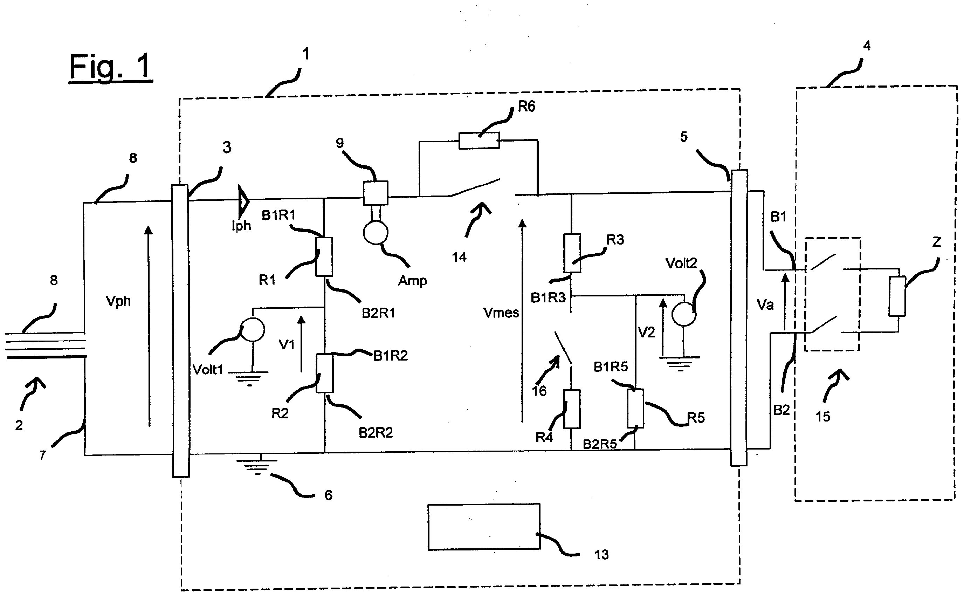

En référence à la figure 1, un compteur d'énergie électrique 1 de l'invention selon un premier mode de réalisation est ici connecté à une ligne électrique triphasée 2 d'un réseau de distribution électrique via des premiers moyens de raccordement 3, et à deux bornes B1, B2 d'une installation électrique 4 via des seconds moyens de raccordement 5.

La ligne électrique 2 permet de transporter une énergie électrique, fournie par un distributeur d'énergie, pour alimenter l'installation électrique 4. Le compteur électrique 1 est ici un compteur triphasé et référencé au neutre, c'est-à-dire qu'une masse électrique 6 du compteur 1 est connectée à un conducteur de neutre 7 de la ligne 2. La ligne comprend trois conducteurs de phase 8 dont seul un est représenté à la figure 1 pour des raisons de clarté de la figure.

Le compteur comprend un transformateur 9 monté en série sur le conducteur de phase 8 pour transformer le courant de la ligne en un courant adapté à l'installation, et pour isoler le conducteur de phase 8 du reste du compteur 1 (référencé au neutre).

Le compteur 1 est agencé pour mesurer une quantité d'énergie électrique consommée par l'installation électrique 4, afin que le distributeur puisse facturer cette énergie électrique à un utilisateur de l'installation 4. Pour cela, le compteur électrique 1 comporte, pour chacun des trois conducteurs de phase 8 de la ligne, des moyens de mesure d'un courant de phase Iph circulant sur le conducteur de phase 8 sous une tension de phase Vph, et des moyens de mesure amont de la tension de phase Vph (seuls les moyens de mesure d'une phase 8 sont représentés sur la figure 1).

Les moyens de mesure du courant de phase comportent un capteur de courant Amp connecté à un secondaire du transformateur 9 qui permet de réduire l'amplitude du courant de phase Iph pour l'adapter au capteur de courant Amp. Le capteur de courant Amp mesure donc un courant d'amplitude réduite circulant dans ce secondaire et dont l'amplitude est proportionnelle à celle du courant de phase Iph.

Les moyens de mesure amont de la tension de phase Vph sont situés en amont du transformateur 9 et des moyens de mesure du courant Amp (c'est-à-dire côté réseau), et sont adaptés à mesurer une tension entre le conducteur de phase 8 et le conducteur de neutre 7 de la ligne 2. Ils comprennent une première résistance amont R1, une deuxième résistance amont R2, et un premier capteur de tension Volt1. La première résistance amont R1 comporte une première borne B1R1 connectée au conducteur de phase 8 et une deuxième borne B2R1 connectée à une première borne B1R2 de la deuxième résistance amont R2. Une deuxième borne B2R2 de la deuxième résistance amont R2 est connectée au conducteur de neutre 7. Le premier capteur de tension Volt1 est agencé pour mesurer le potentiel de la borne B2R1 (ou de la borne B1R2), ce qui permet d'obtenir par division de tension une tension V1 proportionnelle à la tension de phase Vph et de laquelle la tension de phase Vph se déduit facilement.

Par « capteur de courant » et « capteur de tension », on entend un ensemble de composants de mesure comprenant notamment un convertisseur analogique numérique et permettant de réaliser une mesure de courant ou de tension analogique et de transformer cette mesure en données numériques.

Les acquisitions de mesures du courant de phase Iph et de la tension de phase Vph sont réalisées par des moyens de traitement 13 du compteur électrique 1, qui sont avantageusement adaptés à mémoriser ces mesures et à les transmettre au distributeur grâce à des moyens de communication (ligne de communication, courants porteurs, etc.) non représentés ici. Les mesures sont acquises soit régulièrement, à une fréquence définie par les moyens de traitement, soit suite à une commande extérieure transmise aux moyens de traitement 13 via les moyens de communication.

Ainsi, grâce au compteur 1, le distributeur peut connaître la puissance électrique consommée par l'installation, et donc en déduire une énergie électrique consommée.

Le compteur 1 est de plus agencé pour permettre au distributeur de couper ou de rétablir à distance l'alimentation électrique de l'installation 4. Pour cela, le compteur 1 comporte un organe de coupure 14 situé dans le compteur 1 en aval du transformateur 9 et des moyens de mesure du courant Amp (c'est-à-dire côté installation électrique). Le distributeur envoie une commande aux moyens de traitement 13 qui pilotent l'organe de coupure 14 pour l'ouvrir ou le refermer selon la commande.

Le compteur 1 est en outre agencé pour mesurer une tension aval Va aux bornes B2 de l'installation, et pour mesurer une impédance Z de l'installation 4.

Une mesure de la tension aval Va permet notamment de connaître un état réel de l'organe de coupure 14 (ouvert ou fermé), et de détecter une éventuelle fraude commise par l'utilisateur, qui aurait court-circuité l'organe de coupure 14 pour brancher l'installation sur le réseau.

Une mesure de l'impédance Z de l'installation, quant à elle, permet notamment au distributeur de connaître l'état d'un disjoncteur 15 en entrée de l'installation 4, et donc de détecter une manoeuvre d'ouverture puis de fermeture du disjoncteur 15 pour commander à distance un réarmement de l'organe de coupure 14. Le réarmement de l'organe de coupure 14 est bien sûr commandé uniquement lorsque l'organe de coupure 14 est ouvert, et donc la mesure de l'impédance Z est nécessaire seulement lorsque l'organe de coupure 14 est ouvert.

Les acquisitions des mesures de tension aval Va et d'impédance Z de l'installation 4 sont réalisées par les moyens de traitement 13, tout comme les acquisitions de mesures de courant de phase et de mesures de tension de phase.

Pour mesurer la tension aval Va aux bornes B2 de l'installation 4, le compteur 1 comporte des moyens de mesure aval comprenant une première résistance aval R3, une première résistance de mesure R4, et un deuxième capteur de tension Volt2. Les résistances R3 et R4 sont connectées en série entre le conducteur de phase 8 et le conducteur de neutre 7.

Le deuxième capteur de tension Volt2 est agencé pour mesurer le potentiel d'une première borne B1R3 de la première résistance aval R3, du côté de la résistance R4, ce qui permet d'obtenir par division de tension une tension V2 proportionnelle à la tension aval Va et à partir de laquelle la tension aval Va se déduit facilement. La première résistance aval R3 et la première résistance de mesure R4 ont ici respectivement une valeur de résistance de 600 kilo-ohms et de 4 kilo-ohms.

Le compteur 1 comporte en outre un interrupteur de mesure 16, dont le rôle sera précisé ci-après, commandé par les moyens de traitement 13 et connecté en série avec la première résistance de mesure R4, de sorte que l'interrupteur est situé entre la résistance R4 et la première borne B1R3.

Pour mesurer l'impédance Z de l'installation 4, le compteur 1 comporte des moyens de mesure d'impédance comprenant une deuxième résistance aval R5.

La deuxième résistance aval R5 est montée en parallèle de l'interrupteur 16 et de la première résistance de mesure R4, de sorte qu'une première borne B1R5 de la deuxième résistance aval R5 est connectée à la borne B1R3, et qu'une deuxième borne B2R5 de la deuxième résistance aval R5 est connectée au conducteur de neutre 7. La deuxième résistance aval R5 a ici une valeur de résistance de 200 kilo-ohms.

L'impédance Z se déduit elle aussi de la tension V2 mesurée par le deuxième capteur de tension Volt2.

Le compteur électrique 1 comporte de plus des moyens d'amenée d'une tension de mesure Vmes aux bornes de l'installation lorsque l'organe de coupure 14 est ouvert. Ainsi, la tension Va aux bornes de l'installation est égale à la tension de phase Vph lorsque l'organe de coupure 14 est fermé, et égale à la tension de mesure Vmes lorsque l'organe de coupure 14 est ouvert.

Ces moyens d'amenée sont ici formés par une résistance d'amenée R6 montée en parallèle de l'organe de coupure 14. La résistance d'amenée R6 a ici une valeur de résistance de 6 méga-ohms. La tension Vmes est donc directement obtenue à partir de la tension Vph par division de tension, et est relativement faible du fait de la valeur élevée de la résistance d'amenée R6.

On décrit désormais le fonctionnement du compteur électrique 1 de l'invention lorsque le distributeur souhaite détecter une manipulation du disjoncteur 15 de l'installation 4 consistant à ouvrir puis refermer le disjoncteur 15, la manipulation ayant pour effet de faire passer le disjoncteur 15 d'un état ouvert (dans lequel l'impédance Z de l'installation est relativement importante), à un état fermé (dans lequel l'impédance Z de l'installation est relativement faible).

Les moyens de traitement 13 commandent tout d'abord une mesure de la tension aval Va, et acquièrent cette mesure, pour connaître l'état réel de l'organe de coupure 14.

Pour cela, les moyens de traitement commandent l'interrupteur de mesure 16 dans un état fermé, de manière à connecter la première résistance de mesure R4 à la résistance d'amenée R6 via la première résistance aval R3. La première résistance de mesure R4 et la deuxième résistance aval R5 sont donc connectées en parallèle.

La valeur de tension V2 fournie par le deuxième capteur de tension Volt2 est donc égale à :

$$V2 = Va\frac{R4//R5}{R3+R4//R5}.$$

Par « R4 // R5 », on désigne la résistance équivalente de R4 en parallèle avec R5.

Comme la valeur de résistance de la résistance de mesure R4 est beaucoup plus faible que celle de la deuxième résistance aval R5, ces résistances en parallèle présentent une résistance équivalente ayant une valeur proche de celle de la résistance de mesure R4. La tension V2 est donc approximativement égale à :

$$V2 = Va\frac{R4}{R3+R4}.$$

Ainsi, si l'organe de coupure 14 est ouvert, et donc si Va = Vmes, la tension V2 mesurée par le deuxième capteur de tension Volt2 est relativement faible, alors que si l'organe de coupure 14 est fermé, et que Va = Vph, la tension V2 mesurée est relativement élevée.

On perçoit ici l'intérêt d'avoir choisi une première résistance de mesure R4 ayant une valeur de résistance faible. En effet, lorsque l'organe de coupure est fermé, la tension aux bornes de l'installation est élevée, et donc la tension aval Va (égale à la tension de phase Vph) doit être suffisamment divisée, d'une part pour être adaptée au deuxième capteur de tension Volt2, qui est adapté à mesurer des tensions d'entrée relativement faibles, et d'autre part, pour que le capteur de tension Volt 2 puisse détecter des variations relativement précises de l'impédance sur une gamme large de valeurs possibles d'impédance de l'installation.

Ainsi, les moyens de traitement peuvent détecter si l'organe de coupure est ouvert ou fermé. On note que si l'organe de coupure est détecté fermé alors qu'une commande du distributeur l'avait préalablement ouvert, l'organe de coupure a probablement été court-circuité par l'utilisateur. Un cas de fraude est alors détecté. Bien sûr, la résistance d'amenée R6 est suffisamment importante pour rendre Vmes suffisamment faible d'une part pour ne pas permettre l'alimentation de l'installation et d'autre part pour distinguer un cas de fraude (dans lequel l'organe de coupure est censé être ouvert, mais dans lequel la tension aval Va est relativement importante), et un cas d'ouverture de l'organe de coupure sans fraude (dans lequel la tension aval Va mesurée est égale à Vmes).

Si l'organe de coupure 14 est détecté fermé, il n'est pas nécessaire de le réarmer, et donc une mesure de l'impédance Z de l'installation 4 n'est pas nécessaire.

Si l'organe de coupure 14 est détecté ouvert, une mesure de l'impédance Z est commandée et acquise par les moyens de traitement 13. Les moyens de traitement 13 commandent l'ouverture de l'interrupteur de mesure 16. La tension V2 mesurée par le deuxième capteur de tension Volt2 est donc égale à :

$$V2 = Vmes \frac{R5}{R3+R5}.$$

Or, par division de la tension Vph par les résistances R3, R5, R6 et par l'impédance Z, on a :

$$Vmes = Vph \frac{Z//(R3+R5)}{R6+(Z//(R3+R5))}.$$

On obtient donc pour V2 :

$$V2 = Vph \frac{Z//(R3+R5)}{R6+(Z//(R3+R5))} \frac{R5}{R3+R5}.$$

Ainsi, la tension mesurée V2 dépend directement de l'impédance Z de l'installation. Il est donc possible de détecter une variation importante de Z, correspondant à la manoeuvre du disjoncteur évoqué précédemment. Avantageusement, on prévoit de réutiliser la valeur de Vph fournie par le premier capteur de tension Volt1, ce qui permet de prendre en compte une valeur Vph correcte, et d'éviter de détecter une variation d'impédance Z en cas de variation de tension de phase Vph.

On perçoit ici l'intérêt d'avoir choisi une deuxième résistance aval R5 ayant une valeur de résistance importante. Comme la tension aval (égale à Vmes) est relativement faible, il est nécessaire d'avoir une deuxième résistance aval R5 de valeur de résistance importante pour que V2 ait une valeur suffisante permettant au capteur de tension Volt 2 de détecter des variations relativement précises de l'impédance sur une gamme large de valeurs possibles d'impédance Z de l'installation 4.

Les moyens de traitement 13 sont ici adaptés, par des moyens logiciels appropriés, à détecter que le disjoncteur 15 est ouvert lorsque l'impédance Z de l'installation 4 mesurée est supérieure à une première valeur seuil égale à 100 kilo-ohms, ou fermé lorsque l'impédance mesurée est inférieure à une deuxième valeur seuil égale à 10 kilo-ohms. Les résistances R1, R2, R3, R4, R5, R6, ainsi que les capteurs de tension Volt1, Volt2, ont des caractéristiques électriques (précision, tolérance, etc.) permettant de distinguer de manière fiable une impédance Z inférieure à 10 kilo-ohms et une impédance Z supérieure à 100 kilo-ohms.

La première valeur seuil peut sembler relativement faible, mais elle correspond à des installations comportant des longueurs de fils électriques importantes reliant le compteur 1 au disjoncteur 15, ou le disjoncteur 15 au reste de l'installation 4. La seconde valeur seuil, quant à elle, correspond à une très faible charge de l'installation 4, et donc à une faible consommation d'énergie électrique.

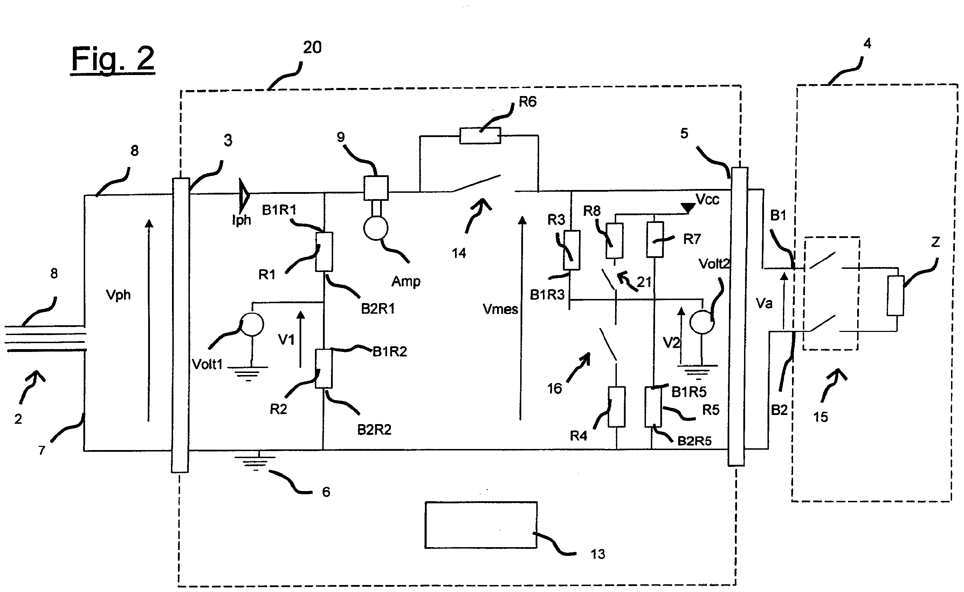

Une variante 20 du compteur électrique de l'invention est représentée à la figure 2. Tous les éléments de la figure 2 déjà présents sur la figure 1 ont conservé leur référence.

Les moyens de mesure aval comportent, outre les éléments précédemment cités, une source de tension continue Vcc connectée au deuxième capteur de tension Volt2 via une deuxième résistance de mesure R8.

Cette source de tension continue Vcc permet d'ajouter à la tension V2 mesurée par le deuxième capteur de tension Volt2 une composante de tension continue, dans le cas où le capteur de tension Volt2 nécessiterait une entrée ayant une telle composante continue (par exemple, dans le cas où un convertisseur analogique numérique de Volt2 est alimenté par une unique tension d'alimentation positive, et non par une tension d'alimentation positive et une tension d'alimentation négative).

Les moyens de mesure d'impédance comportent quant à eux une troisième résistance aval R7.

On munit de plus le compteur électrique 20 d'un interrupteur de mesure supplémentaire 21.

La deuxième résistance de mesure R8 et l'interrupteur de mesure supplémentaire 21 sont montés en série entre la source de tension continue Vcc et le premier interrupteur de mesure 16. La troisième résistance aval R7 est montée en parallèle de l'interrupteur 21 et de la deuxième résistance de mesure R8.

Tout comme l'interrupteur de mesure 16, l'interrupteur supplémentaire 21 est fermé par les moyens de traitement 13 pour mesurer la tension aval Va, et ouvert pour mesurer l'impédance Z de l'installation 4. Ici, la valeur de résistance de la troisième résistance aval R7 est égale à celle de la deuxième résistance aval R5, et la valeur de résistance de la deuxième résistance de mesure R8 est égale à celle de la première résistance de mesure R4.

L'invention n'est pas limitée au mode de mise en oeuvre particulier et à la variante qui viennent d'être décrits, mais, bien au contraire, couvre toute variante entrant dans le cadre de l'invention telle que définie par les revendications.

Bien que l'on ait choisi de munir le compteur d'un unique ensemble de mesure comprenant un interrupteur de mesure et une première résistance de mesure et, dans le cas de la variante décrite, d'un unique ensemble de mesure supplémentaire comprenant un interrupteur de mesure supplémentaire et une deuxième résistance de mesure, il serait possible d'utiliser plusieurs ensembles de mesure (chacun comprenant un interrupteur et une résistance de mesure) montés en parallèle les uns par rapport aux autres. On définirait ainsi une pluralité de « gammes de mesure », une gamme de mesure correspondant, dans le compteur ici décrit, à un ensemble de valeurs prises par la tension mesurée par le deuxième capteur de tension V2 et permettant de déterminer la tension aval Va, ou à un ensemble de valeurs permettant de détecter une variation d'impédance Z de l'installation. Il serait aussi possible, dans le cas où une pluralité d'ensemble serait utilisée, de ne pas commander simultanément tous les interrupteurs pour définir un nombre plus important de gammes de mesure. Ainsi, avec deux ensembles de mesure montés en parallèle, on pourrait définir trois gammes de mesure (correspondant à un interrupteur ouvert et un interrupteur fermé, à deux interrupteurs fermés, et à deux interrupteurs ouverts). Augmenter le nombre de gammes de mesure permet de donner au distributeur la possibilité de mesurer des valeurs de tension aval ou d'impédance plus précises, ou bien dans des gammes de valeurs différentes plus nombreuses.

Bien que l'on ait fourni un certain nombre de valeurs numériques pour des caractéristiques électriques de certains composants (valeur de résistance, etc.), il est bien sûr possible de choisir des valeurs différentes pour ces caractéristiques.

## Revendications

1. Compteur d'énergie électrique (1, 20) comportant des moyens (3, 5) de son raccordement à un réseau de distribution et à des bornes d'une installation électrique (4), des moyens de mesure amont (R1, R2, Volt1) d'une tension de phase (Vph) du réseau, des moyens de mesure (9, Amp) d'un courant de phase (Iph) circulant sous la tension de phase (Vph), un organe de coupure (14) pour sélectivement connecter et déconnecter le réseau et les bornes, des moyens de mesure aval (R3, R4, Volt2) d'une tension aval (Va) aux bornes de l'installation (4), et des moyens de traitement (13) pour piloter l'organe de coupure (14) entre un état ouvert et un état fermé et acquérir des mesures réalisées par les moyens de mesure,
   **caractérisé en ce que** le compteur (1, 20) comporte des moyens d'amenée (R6) d'une tension de mesure aux bornes de l'installation lorsque l'organe de coupure (14) est ouvert, des moyens de mesure (R5) d'impédance connectés aux moyens d'amenée pour mesurer une impédance (Z) de l'installation (4), et au moins un interrupteur de mesure (16) connecté à une première résistance de mesure (R4) des moyens de mesure aval et commandé par les moyens de traitement (13) pour sélectivement connecter et déconnecter la première résistance de mesure (R4) et les moyens d'amenée (R6) selon qu'une mesure de tension aval ou qu'une mesure d'impédance est commandée.

2. Compteur d'énergie électrique (1, 20) selon la revendication 1 comportant une pluralité d'interrupteurs de mesure montés en parallèle les uns par rapport aux autres, chaque interrupteur étant connecté à une première résistance de mesure des moyens de mesure aval et étant commandé par les moyens de traitement.

3. Compteur d'énergie électrique (1, 20) selon l'une des revendications précédentes, dans lequel les moyens d'amenée de la tension de mesure comportent une résistance d'amenée (R6) montée en parallèle de l'organe de coupure (14).

4. Compteur d'énergie électrique (1, 20) selon l'une des revendications précédentes, dans lequel les moyens de mesure aval comportent une première résistance aval (R3) montée en série avec l'interrupteur de mesure (16) et la première résistance de mesure (R4), et les moyens de mesure d'impédance comportent une deuxième résistance aval (R5) montée en parallèle avec l'interrupteur de mesure (16) et la première résistance de mesure (R4), la mesure de tension aval et la mesure d'impédance étant obtenues par division de tension de la tension aux bornes de l'installation.

5. Compteur d'énergie électrique (1, 20) selon la revendication 4, dans lequel les moyens de mesure aval comportent une source de tension continue (Vcc) connectée à au moins une deuxième résistance de mesure (R8), et dans lequel les moyens de mesure d'impédance comportent une troisième résistance aval (R7) connectée à la source de tension continue et à la deuxième résistance aval (R5), le compteur comportant en outre un interrupteur de mesure supplémentaire (21) connecté en série avec la deuxième résistance de mesure (R8), l'interrupteur de mesure supplémentaire et la deuxième résistance de mesure (R8) étant montés en parallèle avec la troisième résistance aval (R7).

6. Compteur d'énergie électrique (1, 20) selon l'une des revendications 4 ou 5, dans lequel la valeur de résistance de la deuxième résistance aval (R5) est comprise entre dix fois et cent fois la valeur de résistance de chaque résistance de mesure (R4, R8).

7. Compteur d'énergie électrique (1, 20) selon l'une des revendications précédentes, le compteur étant adapté à mesurer la tension aval de manière à déterminer un état réel de l'organe de coupure (14), puis, si l'organe de coupure (14) est ouvert, à mesurer l'impédance de l'installation.

**Patentansprüche**

1. Stromzähler (1, 20), umfassend Mittel (3, 5) für seine Verbindung mit einem Stromversorgungsnetz und mit Klemmen einer elektrischen Anlage (4), stromaufwärtige Messmittel (R1, R2, Volt1) zum Messen einer Phasenspannung (Vph) des Netzes, Messmittel (9, Amp) zum Messen eines Phasenstroms (Iph), der unter der Phasenspannung (Vph) fließt, ein Trennelement (14) zum selektiven Verbinden und Trennen des Netzes und der Klemmen, stromabwärtige Messmittel (R3, R4, Volt2) zum Messen einer stromabwärtigen Spannung (Va) an den Klemmen der Anlage (4), und Verarbeitungsmittel (13) zum Steuern des Trennelements (14) zwischen einem geöffneten Zustand und einem geschlossenen Zustand und zum Erfassen von Messungen, die mit den Messmitteln durchgeführt werden, **dadurch gekennzeichnet, dass** der Zähler (1, 20) Zuführungsmittel (R6) zum Zuführen einer Messspannung an die Klemmen der Anlage umfasst, wenn das Trennelement (14) geöffnet ist, Impedanzmessmittel (R5), die mit den Zuführungsmitteln verbunden sind, um eine Impedanz (Z) der Anlage (4) zu messen, und mindestens einen Messunterbrecher (16), der an einen ersten Messwiderstand (R4) der stromabwärtigen Messmittel angeschlossen ist und von den Verarbeitungsmitteln (13) gesteuert wird, um den ersten Messwiderstand (R4) und die Zuführungsmittel (R6) selektiv zu verbinden und zu trennen, je nachdem ob eine stromaufwärtige Spannungsmessung oder eine Impedanzmessung gesteuert wird.

2. Stromzähler (1, 20) nach Anspruch 1, umfassend eine Vielzahl von Messunterbrechern, die parallel zueinander geschaltet sind, wobei jeder Unterbrecher mit einem ersten Messwiderstand der stromabwärtigen Messmittel verbunden ist und von den Verarbeitungsmitteln gesteuert wird.

3. Stromzähler (1, 20) nach einem der vorhergehenden Ansprüche, bei dem die Zuführungsmittel zum Zuführen der Messspannung einen Zuführungswiderstand (R6) umfassen, der parallel zum Trennelement (14) geschaltet ist.

4. Stromzähler (1, 20) nach einem der vorhergehenden Ansprüche, bei dem die stromabwärtigen Messmittel einen stromabwärtigen ersten Widerstand (R3) umfassen, der in Reihe mit dem Messunterbrecher (16) und dem ersten Messwiderstand (R4) geschaltet ist, und die Impedanzmessmittel einen stromabwärtigen zweiten Widerstand (R5) umfassen, der parallel zum Messunterbrecher (16) und zum ersten Messwiderstand (R4) geschaltet ist, wobei die stromabwärtige Spannungsmessung und die Impedanzmessung durch Spannungsteilung der Spannung an den Klemmen der Anlage erhalten werden.

5. Stromzähler (1, 20) nach Anspruch 4, bei dem die stromabwärtigen Messmittel eine Gleichspannungsquelle (Vcc) umfassen, die mit mindestens einem zweiten Messwiderstand (R8) verbunden ist, und bei dem die Impedanzmessmittel einen stromabwärtigen dritten Widerstand (R7) umfassen, der mit der Gleichspannungsquelle und mit dem stromabwärtigen zweiten Widerstand (R5) verbunden ist, wobei der Zähler ferner einen zusätzlichen Messunterbrecher (21) umfasst, der in Reihe mit dem zweiten Messwiderstand (R8) geschaltet ist, wobei der zusätzliche Messunterbrecher und der zweite Messwiderstand (R8) parallel zum stromabwärtigen dritten Widerstand (R7) geschaltet sind.

6. Stromzähler (1, 20) nach einem der Ansprüche 4 oder 5, bei dem der Widerstandswert des stromabwärtigen zweiten Widerstandes (R5) zwischen dem zehnfachen und dem hundertfachen Widerstandswert jedes Messwiderstandes (R4, R8) liegt.

7. Stromzähler (1, 20) nach einem der vorhergehenden Ansprüche, wobei der Zähler geeignet ist, die stromabwärtige Spannung derart zu messen, dass ein Istzustand des Trennelements (14) bestimmt wird, und dann, wenn das Trennelement (14) geöffnet ist, die Impedanz der Anlage gemessen wird.

**Claims**

1. An electricity meter (1, 20) having means (3, 5) for connection to a distribution network and to terminals of an electricity installation (4), upstream measurement means (R1, R2, Volt1) for measuring a phase voltage (Vph) of the network, measurement means (9, Amp) for measuring a phase current (Iph) flowing at the phase voltage (Vph), a cutoff member (14) for selectively connecting and disconnecting the network and the terminals, downstream measurement means (R3, R4, Volt2) for measuring a downstream voltage (Va) across the terminals of the installation (4), and processor means (13) for operating the cutoff switch (14) between an open state and a closed state and for acquiring measurements made by the measurement means, the meter (1, 20) being **characterized in that** it includes delivery means (R6) for bringing a measurement voltage to the terminals of the installation when the cutoff member (14) is open, impedance measurement means (R5) connected to the delivery means to measure an impedance (Z) of the installation (4), and at least one measurement switch (16) connected to a first measurement resistor (R4) of the downstream measurement means and controlled by the processor means (13) to connect and disconnect the first measurement resistor (R4) and the delivery means (R6) selectively depending on whether a downstream voltage measurement or an impedance measurement is to be made.

2.  An electricity meter (1, 20) according to claim 1, including a plurality of measurement switches connected in parallel with one another, each switch being connected to a first measurement resistor of the downstream measurement means and being controlled by the processor means.

3.  An electricity meter (1, 20) according to either preceding claim, wherein the delivery means for bringing a measurement voltage comprise a delivery resistor (R6) connected in parallel with the cutoff member (14).

4.  An electricity meter (1, 20) according to any preceding claim, wherein the downstream measurement means comprise a first downstream resistor (R3) connected in series with the measurement switch (16) and the first measurement resistor (R4), and the impedance measurement means comprise a second downstream resistor (R5) connected in parallel with the measurement switch (16) and the first measurement resistor (R4), the downstream voltage and the impedance being measured by voltage division of the voltage across the terminals of the installation.

5.  An electricity meter (1, 20) according to claim 4, wherein the downstream measurement means comprise a source of DC voltage (Vcc) connected to at least one measurement resistor (R8), and wherein the impedance measurement means comprise a third downstream resistor (R7) connected to the source of DC voltage and to the second downstream resistor (R5), the meter also including an additional measurement switch (21) connected in series with the second measurement resistor (R8), the additional measurement switch and the second measurement resistor (R8) being connected in parallel with the third downstream resistor (R7).

6.  An electricity meter (1, 20) according to claim 4 or claim 5, wherein the resistance of the second downstream resistor (R5) lies in the range ten times to one hundred times the resistance of each measurement resistor (R4, R8).

7.  An electricity meter (1, 20) according to any preceding claim, the meter being adapted to measure the downstream voltage in such a manner as to determine a real state of the cutoff member (14), and then if the cutoff member (14) is open, to measure the impedance of the installation.

Fig. 1

EP 2 904 410 B1

**Fig. 2**

EP 2 904 410 B1

**EP 2 904 410 B1**

**RÉFÉRENCES CITÉES DANS LA DESCRIPTION**

**Documents brevets cités dans la description**

*   FR 2947055 A1